# EUROPEAN PATENT APPLICATION

(11) **EP 4 571 282 A1**
(43) Date of publication of application: **18.06.2025**
(21) Application number: 24219281.3
(22) Date of filing: 12.12.2024
(51) Int. Cl.: G01M 3/16, G08B 21/20, H02H 5/08

(54) **SENSING CIRCUIT, DETERMINATION CIRCUIT, SYSTEM AND METHOD FOR AN ELECTRICAL DEVICE**

(30) Priority: 15.12.2023 CN 202311733772
(71) Applicant: Harting International Innovation AG, 2504 Biel (CH)
(72) Inventor: WU, Zhiyang, 2504 BIEL (CH)
(74) Representative: noventive Patentanwaltsgesellschaft mbH

(57) **Abstract**

The present application discloses a sensing circuit (10), a determination circuit (11), a system and a method for an electrical device. The sensing circuit (10) is arranged on an inner surface of the electrical device, and the sensing circuit (10) further comprises: a first circuit board (102), comprising a sensor wire (1021) connected to an external power source and arranged on the first circuit board (102) in a 2D mesh structure, and multiple through-holes (1022), each of the through-holes (1022) being located in each of multiple cells formed by the 2D mesh structure, and penetrating the first circuit board (102) in a thickness direction; and a second circuit board (103) facing the first circuit board (102), with electrically conductive posts (1031) provided on the second circuit board (103) at a position corresponding to each cell of the first circuit board (102), the electrically conductive posts (1031) extending in the thickness direction and having an end with the same shape as the through-hole, multiple said electrically conductive posts being electrically connected to each other and grounded; said end of the electrically conductive posts (1031) being located in the through-holes and in contact with a side face of the through-hole, wherein a change in resistance of the sensing circuit (10) occurs when the sensor wire (1021) is connected via a medium to the electrically conductive posts (1031) in the through-holes.

## Description

### Technical field

The present disclosure relates to resistive sensing technology, in particular to a sensing circuit and a determination circuit for an electrical device, and a system and method for measuring an extent of water ingress into an electrical device.

### Background art

Due to design flaws or omissions during assembly, electrical devices (e.g. heavy duty connectors) are not always fully protected against water ingress.

Such electrical devices thus develop faults due to the ingress of water or moisture, but maintenance operations performed on electrical devices at the present time generally consist of periodical disassembly and reassembly in order to perform visual inspection, thus eliminating operational safety issues, and these maintenance operations consume a lot of time, effort and money.

In response to the problems in the prior art, the present disclosure proposes a system and method for measuring an extent of water ingress into an electrical device, which are able to sense the extent of dampness of an inner surface of the electrical device through a change in resistance, and issue an alert to the effect that the electrical device has already suffered water ingress or is at risk of suffering water ingress. The present disclosure can reliably and accurately judge whether the electrical device is in a good operating condition.

### Summary of the invention

Embodiments of the present disclosure provide a sensing circuit, a determination circuit, a system and a method for an electrical device, to at least solve the problems in the prior art that maintenance operations consume a lot of time, effort and money, and operating conditions are judged with poor reliability.

According to one aspect of the present application, a sensing circuit disposed in an electrical device is provided, the sensing circuit being arranged on an inner surface of the electrical device, and the sensing circuit further comprising: a first circuit board, comprising a sensor wire connected to an external power source and arranged on the first circuit board in a 2D mesh structure, and multiple through-holes, each of the through-holes being located in each of multiple cells formed by the 2D mesh structure, and penetrating the first circuit board in a thickness direction; and a second circuit board facing the first circuit board, with electrically conductive posts provided on the second circuit board at a position corresponding to each cell of the first circuit board, the electrically conductive posts extending in the thickness direction and having an end with the same shape as the cell, multiple said electrically conductive posts being electrically connected to each other and grounded; said end of the electrically conductive posts being located in the through-holes and in contact with a side face of the through-holes, wherein a change in resistance of the sensing circuit occurs when the sensor wire is connected via a medium to the electrically conductive posts in the through-holes.

In this way, the grid-like resistive sensing circuit differentiates degrees of water ingress inside the electrical device or degrees of wetness on the inner surface. Compared with sensing a change in resistance through the connection of two parallel wires via a medium, and the drawback of a large range of resistance variation in the prior art, the sensing circuit of the present disclosure defines a range of resistance variation, and ensures that a change in resistance is independent of the specific position in the sensing circuit where water or water vapour condenses and enters, thus increasing the accuracy and reliability of the detected change in resistance.

According to an exemplary embodiment of the present application, said end is flush with the cell.

In this way, as the end is flush with the cell, i.e. an upper surface of the end is flush with an upper surface of the cell, the accuracy with which the sensor wire is connected via a medium to the electrically conductive posts in the through-holes can be further improved.

According to an exemplary embodiment of the present application, a gap between a side edge of the cell and a side edge on the same side of the electrically conductive posts is 0.1 mm - 0.4 mm.

In this way, within the scope permitted by a manufacturing process, the smaller the gap, the higher the reliability and accuracy with which the sensor wire is connected via a medium to the electrically conductive posts in the through-holes, i.e. the higher the reliability and accuracy of the change in resistance; therefore, the gap is preferably 0.1 - 0.4 mm.

According to an exemplary embodiment of the present application, the interior of the electrically conductive posts is filled with an electrically conductive resin.

In this way, filling with the electrically conductive resin can prevent flow or lingering of the medium (e.g. water or water vapour condensation) that connects the sensor wire to the electrically conductive posts in the through-holes, thereby increasing the reliability and accuracy of the change in resistance.

According to another aspect of the present application, a system for measuring an extent of water ingress into an electrical device is provided, the system comprising the electrical device, and the system further comprising: the sensing circuit described above; and a determination circuit, for determining an extent of water ingress into the electrical device according to the change in resistance.

In this way, the system detects a change in resistance with increased accuracy and reliability by means of the sensing circuit, and determines the extent of water ingress into the electrical device with increased accuracy and reliability by means of the determination circuit.

According to an exemplary embodiment of the present application, the determination circuit comprises a detection circuit, which is connected to the sensor wire and the second circuit board to measure an amount of a change in resistance of the sensing circuit.

In this way, the detection circuit converts the change in resistance to a specific, quantifiable resistance change amount, in order to judge an operating condition of the electrical device subsequently according to this amount.

According to an exemplary embodiment of the present application, the determination circuit further comprises at least one branch determination circuit for determining an extent of water ingress into the electrical device, each of the at least one branch determination circuit being electrically connected to the detection circuit to receive the amount of the change in resistance from the detection circuit.

According to an exemplary embodiment of the present application, the at least one branch determination circuit comprises a first branch determination circuit and a second branch determination circuit, the first branch determination circuit having a first resistance threshold, and the second branch determination circuit having a second resistance threshold higher than the first resistance threshold.

In this way, the determination circuit comprises two branch determination circuits, and two resistance thresholds are thus set.

According to an exemplary embodiment of the present application, the determination circuit compares the amount of the change in resistance with the first resistance threshold and the second resistance threshold, wherein, when the amount of the change in resistance is less than the first resistance threshold, the determination circuit outputs a signal indicating that the electrical device has not suffered water ingress; when the amount of the change in resistance is greater than the first resistance threshold and less than the second resistance threshold, the determination circuit outputs a signal indicating that the electrical device is at risk of suffering water ingress; and when the amount of the change in resistance is greater than the second resistance threshold, the determination circuit outputs a signal indicating that the electrical device has already suffered water ingress.

In this way, by comparing the amount of the change in resistance with different resistance thresholds, and thereby differentiating multiple levels for the extent of water ingress into the electrical device, it is possible to determine the extent of water ingress into the electrical device accurately from multiple different levels. In addition, the multiple different resistance thresholds may be set flexibly according to different applications, and the system for measuring an extent of water ingress into an electrical device can thus be widely applied in various scenarios.

According to another aspect of the present application, a method for measuring an extent of water ingress into an electrical device is provided, the method comprising: receiving a change in resistance of the sensing circuit described above; and determining an extent of water ingress into the electrical device according to the change in resistance.

In this way, by detecting a change in resistance with increased accuracy and reliability, the extent of water ingress into the electrical device is determined with increased accuracy and reliability.

According to an exemplary embodiment of the present application, an amount of the change in resistance is measured; a first resistance threshold and a second resistance threshold higher than the first resistance threshold are received; the amount of the change in resistance is compared with the first resistance threshold and the second resistance threshold, wherein, when the amount of the change in resistance is less than the first resistance threshold, a signal indicating that the electrical device has not suffered water ingress is outputted; when the amount of the change in resistance is greater than the first resistance threshold and less than the second resistance threshold, a signal indicating that the electrical device is at risk of suffering water ingress is outputted; and when the amount of the change in resistance is greater than the second resistance threshold, a signal indicating that the electrical device has already suffered water ingress is outputted.

According to another aspect of the present application, a determination circuit for measuring an extent of water ingress into an electrical device is provided, the determination circuit comprising: a detector, for receiving a change in resistance of the sensing circuit described above and measuring an amount of the change in resistance; and a comparator, for receiving the amount of the change in resistance from the electrical device, and determining an extent of water ingress into the electrical device according to the amount of the change in resistance.

According to an exemplary embodiment of the present application, the determination circuit further comprises a threshold receiving end, for receiving a first resistance threshold and a second resistance threshold higher than the first resistance threshold.

According to an exemplary embodiment of the present application, the comparator receives the first resistance threshold and the second resistance threshold from the threshold receiving end, and compares the amount of the change in resistance with the first resistance threshold and the second resistance threshold, wherein, when the amount of the change in resistance is less than the first resistance threshold, the comparator outputs a signal indicating that the electrical device has not suffered water ingress; when the amount of the change in resistance is greater than the first resistance threshold and less than the second resistance threshold, the comparator outputs a signal indicating that the electrical device is at risk of suffering water ingress; and when the amount of the change in resistance is greater than the second resistance threshold, the comparator outputs a signal indicating that the electrical device has already suffered water ingress.

In embodiments of the present application, a technical solution is provided in which a grid-like resistive sensing circuit detects a change in resistance with increased accuracy, and a determination circuit compares this change in resistance with different resistance thresholds so as to accurately judge an extent of water ingress into an electrical device; this technical solution is provided in order to at least solve the technical problems in the prior art that maintenance operations on electrical devices consume a lot of time, effort and money, and operating conditions are judged with low accuracy. Thus, the technical effect of judging an operating condition of an electrical device reliably and accurately is achieved.
The sensing circuit and/or the determining circuit, in any configuration or embodiment described hereinbefore, may be used and incorporated in an industrial plug connector as disclosed, for example, in EP 3815192 A1. The said industrial plug connector thereby embodies the device and/or system in any configuration or embodiment as described hereinbefore.
By using the sensing circuit and/or the determining circuit in said industrial plug connector, water ingress can be detected with high reliability in addition to the amount of water (extent of water ingress) entering the industrial plug connector housing, for example when mated. Industrial plug connectors are specially designed for industrial applications where a high level of protection against dust and water ingress is required and where high demands are placed on mechanical vibration. Industrial plug connectors are therefore particularly robust and have a high level of contact stability even at high vibration amplitudes. Industrial plug connectors are sometimes referred to as heavy duty connectors. For this reason, an industrial plug connector is explicitly disclosed, including the sensing and/or determining circuitry.

### Brief description of the drawings

The drawings described here are intended to provide further understanding of the present invention, and form part of the present application. The schematic embodiments of the present application and descriptions thereof are intended to explain the present application, without limiting it inappropriately. In the drawings:
Fig. 1 is a 3D perspective drawing showing a sensing circuit according to an embodiment of the present disclosure.
Fig. 2 is a top view showing a sensing circuit according to an embodiment of the present disclosure.
Fig. 3 is a schematic drawing showing a system according to an embodiment of the present disclosure for measuring an extent of water ingress into an electrical device.
Fig. 4 is a schematic drawing showing a method according to an embodiment of the present disclosure for measuring an extent of water ingress into an electrical device.
Fig. 5 is a more detailed schematic drawing showing a method according to an embodiment of the present disclosure for measuring an extent of water ingress into an electrical device.
Fig. 6 is a schematic drawing showing a determination circuit according to an embodiment of the present disclosure for measuring an extent of water ingress into an electrical device.

### Detailed description of the invention

Embodiments of the present application are described in detail below with reference to the drawings, to make it easy for those skilled in the art to implement embodiments of the present application. However, the present application may be implemented in many different forms, and should not be interpreted as being limited to the embodiments mentioned herein. In the drawings, parts which are irrelevant to the description of the present application are omitted for clarity. Throughout the description, similar reference numerals denote similar elements. In addition, when a description is provided with reference to the drawings, even if elements are represented by the same numerals, the reference numerals relating to the elements may change; moreover, the reference numerals are only described for convenience of description, and should not be construed as limiting the concept, features, functions or effects of the elements.

The aim of the present disclosure is to sense the extent of dampness of an inner surface of an electrical device, sense the extent of water ingress of the inner surface of the electrical device, and reliably and accurately judge an operating condition of the electrical device - specifically, an operating condition whereby the electrical device has not suffered water ingress, an operating condition whereby the electrical device has already suffered water ingress, and an operating condition whereby the electrical device is at risk of suffering water ingress - through a change in resistance of a grid-like resistive sensing circuit. In the term "water ingress" referred to herein, "water" includes a flow of water entering the electrical device from the outside, and also includes water vapour entering the electrical device from the outside.

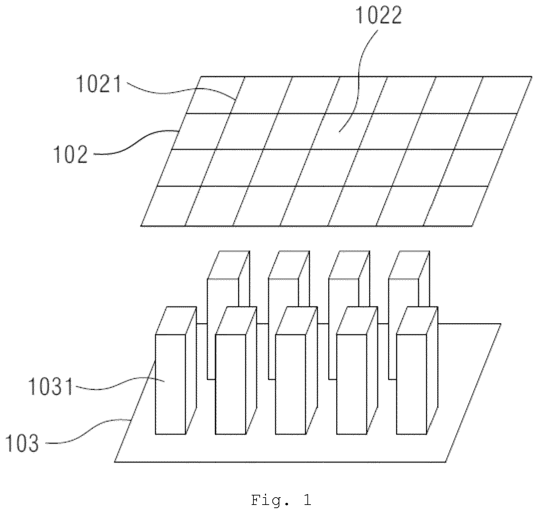

Fig. 1 is a 3D perspective drawing showing a sensing circuit according to an embodiment of the present disclosure.

The sensing circuit 10 is disposed on (e.g. adhered to) an inner surface of an electrical device, which for example is an iron rail heavy duty connector, but the present disclosure is not limited to this. As shown in Fig. 1, the sensing circuit 10 comprises a first circuit board 102 and a second circuit board 103. On the first circuit board 102, a sensor wire 1021 is arranged in a 2D mesh structure and connected to a positive electrode of an external power source, the sensor wire 1021 for example being an exposed copper wire. In accordance with an etching process for PCB manufacturing, a square through-hole 1022 is formed in each of multiple square cells formed by the 2D mesh structure, the square through-hole penetrating the first circuit board 102 in a thickness direction of the first circuit board 102.

In addition, the square through-hole is not necessary. The through-hole could also be round, etc., as long as edges of the through-hole are at equal distances from the cell. The "square through-hole" in this description is merely an example, and not intended to limit the scope of the present invention.

The second circuit board 103 is arranged below the first circuit board 102 and faces the first circuit board 102. On the second circuit board 103, electrically conductive posts 1031 extending in the thickness direction is arranged at a position corresponding to each square cell of the first circuit board 102. For a tight fit with the square through-holes 1022, an end (e.g. an upper end) of the electrically conductive posts 1031 is configured to be square; in addition, bottom ends of the electrically conductive posts 1031 are electrically connected to each other, and grounded via the second circuit board 103.

For clarity, Fig. 1 only shows a 3D perspective drawing in which the electrically conductive posts 1031 have not been tightly fitted to the square through-holes 1022; however, in actual use, the electrically conductive posts 1031 are tightly fitted to the square through-holes 1022.

In addition, Fig. 1 only shows a scenario in which the sensor wire 1021 is connected to the positive electrode of the power source and the second circuit board 103 is grounded; however, the sensor wire 1021 could also be connected to ground, with the second circuit board 103 being connected to the positive electrode of the power source. The present disclosure is not limited to this.

The upper end of the electrically conductive posts 1031 are located in the square through-holes 1022 and in contact with a side face of the square through-holes 1022, specifically, in tight contact with four side faces of the square through-holes 1022.

When the sensor wire 1021 receives power from the power source, and when the sensor wire 1021 is connected via a medium to the electrically conductive posts 1031 in the square through-holes 1022, the resistance of the sensing circuit 10 changes.

Specifically, the sensor wire 1021 may be connected to the electrically conductive posts 1031 in the square through-holes 1022 via an electrically conductive medium, for example water.

When an electrically conductive medium is present, in order to accurately and reliably connect the sensor wire 1021 to the electrically conductive posts 1031 in the square through-holes 1022 via the electrically conductive medium, an end (e.g. upper end) of the electrically conductive posts 1031 is configured to be flush with an upper surface of the square cell. This allows the change in the resistance of the sensing circuit to be measured accurately and reliably.

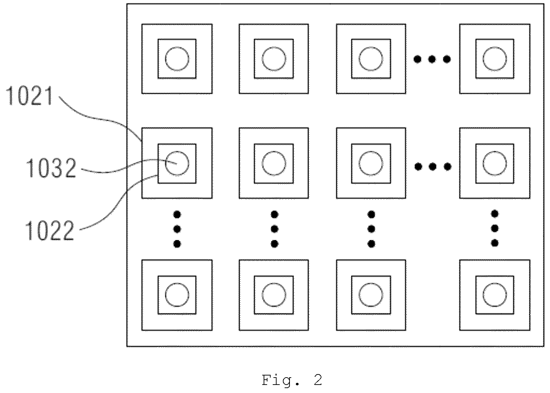

Fig. 2 is a top view showing a sensing circuit according to an embodiment of the present disclosure.

Further, in order to accurately and reliably connect the sensor wire 1021 to the electrically conductive posts 1031 in the square through-holes 1022 via the medium and also take into account a process of manufacturing the PCB, as shown in Fig. 2, a gap between a side edge of a square cell (i.e. a sensor line) and a side edge on the same side of the electrically conductive posts 1031 is etched so as to be 0.1 - 0.4 mm, preferably 0.1 - 0.2 mm. This gap configuration reduces the manufacturing fault rate, and increases the accuracy with which the sensor wire 1021 is connected via the medium to the electrically conductive posts 1031 in the square through-holes 1022, thus allowing the change in the resistance of the sensing circuit to be measured accurately and reliably.

Further, in order to accurately and reliably connect the sensor wire 1021 to the electrically conductive posts 1031 in the through-holes 1022 via the medium, and when the electrically conductive medium is water, each electrically conductive post 1031 is subjected to a resin hole-plugging process, i.e. the interior of the electrically conductive posts 1031 are filled with an electrically conductive resin 1032. The electrically conductive posts 1031 filled with the electrically conductive resin 1032 are not only electrically conductive, but can also prevent a medium on an upper surface thereof from lingering or flowing, thus allowing the change in the resistance of the sensing circuit to be measured accurately and reliably.

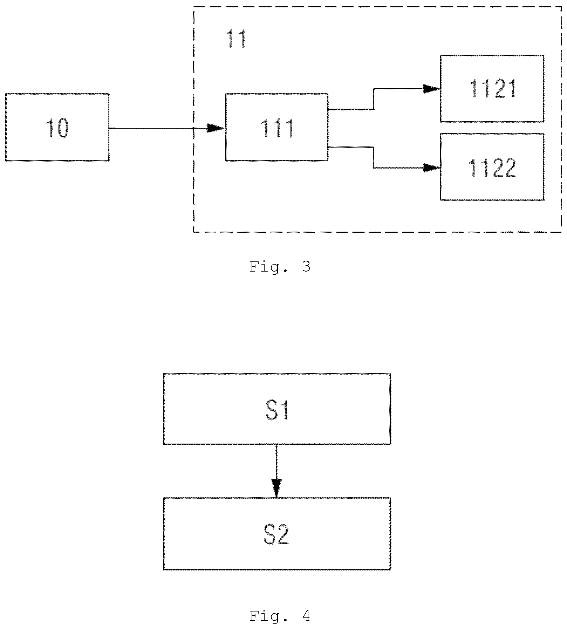

Fig. 3 is a schematic drawing showing a system according to an embodiment of the present disclosure for measuring an extent of water ingress into an electrical device.

As shown in Fig. 3, the system comprises a sensing circuit 10 and a determination circuit 11. The determination circuit 11 comprises a detection circuit 111, a first branch determination circuit 1121 and a second branch determination circuit 1122. The determination circuit 11 determines the extent of dampness or water ingress of an inner surface of the electrical device according to a change in resistance of the sensing circuit 10. Specifically, the detection circuit 111 is connected to the sensor wire 1021 and the second circuit board 103 to measure the amount of the change in resistance of the sensing circuit 10; for example, the detection circuit 111 is a multimeter, etc.

When there is no conduction via a medium on the sensing circuit 10, the sensing circuit does not conduct, or has an initial resistance of 5 Mohm or more; however, where there is conduction via a medium on the sensing circuit 10, the detection circuit 111 measures the present resistance of the sensing circuit 10. Ideally, when a conducting area of the grid-like circuit of the sensing circuit 10 is larger, the resistance is lower for the same conducting medium.

The first branch determination circuit 1121 and the second branch determination circuit 1122 are both connected to the detection circuit 111, so as to receive the amount of the change in resistance from the detection circuit 111. The first branch determination circuit 1121 and the second branch determination circuit 1122 may be realized by comparators for example.

The first branch determination circuit 1121 has a set first resistance threshold, and the second branch determination circuit 1122 has a set second resistance threshold, wherein the second resistance threshold is greater than the first resistance threshold. When the system is applied to different electrical devices, the resistance thresholds can be set according to actual needs. Thus, the application scenarios of the system can be expanded flexibly.

The first branch determination circuit 1121 compares the amount of the change in resistance to the first resistance threshold, and the second branch determination circuit 1122 compares the amount of the change in resistance to the second resistance threshold.

When the amount of the change in resistance is less than the first resistance threshold, the determination circuit 11 outputs a signal indicating that the electrical device has not suffered water ingress; for example, the determination circuit 11 may output the numerals "00". In this case, the signal may also indicate that there is no water mist and no water flow inside the electrical device.

When the amount of the change in resistance is greater than the first resistance threshold and less than the second resistance threshold, the determination circuit outputs a signal indicating that the electrical device is at risk of suffering water ingress; for example, the determination circuit 11 may output the numerals "01". In this case, the signal may also indicate that there is water mist but no water flow inside the electrical device.

When the amount of the change in resistance is greater than the second resistance threshold, the determination circuit outputs a signal indicating that the electrical device has already suffered water ingress; for example, the determination circuit 11 may output the numerals "11". In this case, the signal may also indicate that there is also water flow inside the electrical device.

By comparing the amount of the change in resistance with different resistance thresholds, and thereby differentiating multiple levels for the extent of water ingress into the electrical device, it is possible to determine the extent of water ingress into the electrical device accurately from multiple different levels. In addition, the multiple different resistance thresholds may be set flexibly according to different applications, and the system for measuring an extent of water ingress into an electrical device can thus be widely applied in various scenarios.

An operator of the electrical device can judge an operating condition of the electrical device according to the numerals output by the determination circuit 11. Thus, the operator can judge whether the electrical device is in a good operating condition without needing to disassemble the electrical device.

The system of the present disclosure for measuring an extent of water ingress into an electrical device does not require periodic disassembly and reassembly of the electrical device to perform visual inspection, and thus greatly reduces the amount of time, effort and money associated with maintenance operations, as well as increasing the accuracy with which operating conditions are judged.

In addition, the system of the present disclosure for measuring an extent of water ingress into an electrical device greatly reduces power consumption compared with the prior art as a result of having the sensor wire 1021 connected to the positive electrode of the power source, and supplied with power only when sensing is necessary (i.e. when an electrically conductive medium such as water triggers conduction).

Fig. 4 is a schematic drawing showing a method according to an embodiment of the present disclosure for measuring an extent of water ingress into an electrical device.

As shown in Fig. 4, the method comprises step S1, receiving a change in resistance of a sensing circuit; and step S2, determining an extent of water ingress into the electrical device according to the change in resistance.

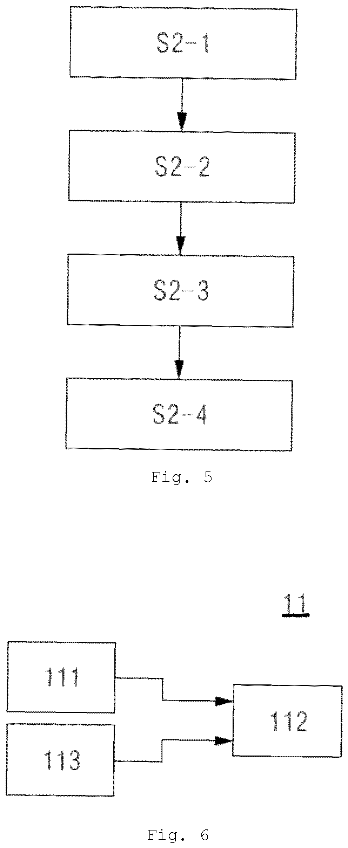

Fig. 5 is a more detailed schematic drawing showing a method according to an embodiment of the present disclosure for measuring an extent of water ingress into an electrical device.

Specifically, step S2 further comprises step S2-1, measuring an amount of a change in resistance; step S2-2, receiving a first resistance threshold and a second resistance threshold higher than the first resistance threshold; step S2-3, comparing the amount of the change in resistance with the first resistance threshold and the second resistance threshold, wherein, when the amount of the change in resistance is less than the first resistance threshold, step S2-4 outputs a signal indicating that the electrical device has not suffered water ingress; when the amount of the change in resistance is greater than the first resistance threshold and less than the second resistance threshold, step S2-4 outputs a signal indicating that the electrical device is at risk of suffering water ingress; and when the amount of the change in resistance is greater than the second resistance threshold, step S2-4 outputs a signal indicating that the electrical device has already suffered water ingress.

Fig. 6 is a schematic drawing showing a determination circuit according to an embodiment of the present disclosure for measuring an extent of water ingress into an electrical device.

As shown in Fig. 6, the determination circuit 11 comprises a detector 111 (i.e. detection circuit 111), a comparator 112 and a threshold receiving end 113. The detector 111 receives a change in resistance of a sensing circuit 10 and measures an amount of the change in resistance. The comparator 112 receives the amount of the change in resistance from the detector, and determines the extent of water ingress into the electrical device according to the amount of the change in resistance; for example, the comparator 112 may also comprise the first branch determination circuit 1121 and the second branch determination circuit 1122 mentioned above. Specifically, the comparator 112 also receives a set first resistance threshold, and a second resistance threshold higher than the first resistance threshold, from the threshold receiving end 113.

Specifically, the comparator 112 compares the amount of the change in resistance with the first resistance threshold and the second resistance threshold, wherein, when the amount of the change in resistance is less than the first resistance threshold, the comparator outputs a signal indicating that the electrical device has not suffered water ingress; when the amount of the change in resistance is greater than the first resistance threshold and less than the second resistance threshold, the comparator outputs a signal indicating that the electrical device is at risk of suffering water ingress; and when the amount of the change in resistance is greater than the second resistance threshold, the comparator outputs a signal indicating that the electrical device has already suffered water ingress.

In embodiments of the present application, a technical solution is provided in which a grid-like resistive sensing circuit detects a change in resistance with increased accuracy, and a determination circuit compares this change in resistance with different resistance thresholds so as to accurately judge an extent of water ingress into an electrical device; this technical solution is provided in order to at least solve the technical problems in the prior art that maintenance operations on electrical devices consume a lot of time, effort and money, and operating conditions are judged with low accuracy. Thus, the technical effect of judging an operating condition of an electrical device reliably and accurately is achieved.

In the above embodiments of the present application, the description of each embodiment has its own focus; for anything not described in detail in an embodiment, the relevant description of another embodiment can be referred to.

In the embodiments provided by the present application, it should be understood that the technical content disclosed may be realized in other ways.

The above are merely preferred embodiments of the present application, and it should be pointed out that a person skilled in the art could still make a number of improvements and modifications without departing from the principles of the present application, and all such improvements and modifications should be regarded as being within the scope of protection of the present application.

### List of references used in figures

- 10:: sensing circuit;
- 11:: determination circuit;
- 102:: first circuit board;
- 1021:: sensor wire;
- 1022:: through-hole;
- 103:: second circuit board;
- 1031:: electrically conductive post;
- 1032:: electrically conductive resin;
- 111:: detection circuit;
- 1121:: first branch determination circuit;
- 1122:: second branch determination circuit;
- S1, S2, S2-1, S2-2, S2-3, S2-4:: steps;
- 112:: comparator;
- 113:: threshold receiving end.

## Claims

1. Sensing circuit (10) disposed in an electrical device, wherein the sensing circuit (10) is arranged on an inner surface of the electrical device, and the sensing circuit (10) further comprises:
a first circuit board (102), comprising:
a sensor wire (1021), connected to an external power source and arranged on the first circuit board (102) in a 2D mesh structure;
multiple through-holes (1022), each of the through-holes (1022) being located in each of multiple cells formed by the 2D mesh structure, and penetrating the first circuit board (102) in a thickness direction;
a second circuit board (103) facing the first circuit board (102), with electrically conductive posts (1031) provided on the second circuit board (103) at a position corresponding to each cell of the first circuit board (102), the electrically conductive posts (1031) extending in the thickness direction and having an end with the same shape as the through-holes, multiple said electrically conductive posts (1031) being electrically connected to each other and grounded;
said end of the electrically conductive posts (1031) being located in the through-holes and in contact with a side face of the through-holes,
wherein a change in resistance of the sensing circuit (10) occurs when the sensor wire (1021) is connected via a medium to the electrically conductive posts (1031) in the through-holes.

2. Sensing circuit (10) according to claim 1, wherein said end is flush with the cell.

3. Sensing circuit (10) according to claim 1 or 2, wherein a gap between a side edge of the cell and a side edge on the same side of the electrically conductive posts (1031) is 0.1 mm - 0.4 mm.

4. Sensing circuit (10) according to any one of the claims 1 to 3, wherein the interior of the electrically conductive posts (1031) is filled with an electrically conductive resin (1032).

5. System for measuring an extent of water ingress into an electrical device, the system comprising the electrical device, wherein the system further comprises:
the sensing circuit (10) according to any one of claims 1 - 4;
a determination circuit (11), for determining an extent of water ingress into the electrical device according to the change in resistance.

6. System according to claim 5, wherein the determination circuit (11) comprises a detection circuit (111), which is connected to the sensor wire (1021) and the second circuit board (103) to measure an amount of a change in resistance of the sensing circuit (10).

7. System according to claim 6, wherein the determination circuit (11) further comprises at least one branch determination circuit (1121, 1122) for determining an extent of water ingress into the electrical device, each of the at least one branch determination circuit (1121, 1122) being electrically connected to the detection circuit (111) to receive the amount of the change in resistance from the detection circuit (111).

8. System according to claim 7, wherein the at least one branch determination circuit (1121, 1122) comprises a first branch determination circuit (1121) and a second branch determination circuit (1122), the first branch determination circuit (1121) having a first resistance threshold, and the second branch determination circuit (1122) having a second resistance threshold higher than the first resistance threshold.

9. System according to claim 8, wherein the determination circuit (11) compares the amount of the change in resistance with the first resistance threshold and the second resistance threshold, wherein, when the amount of the change in resistance is less than the first resistance threshold, the determination circuit (11) outputs a signal indicating that the electrical device has not suffered water ingress; when the amount of the change in resistance is greater than the first resistance threshold and less than the second resistance threshold, the determination circuit (11) outputs a signal indicating that the electrical device is at risk of suffering water ingress; and when the amount of the change in resistance is greater than the second resistance threshold, the determination circuit (11) outputs a signal indicating that the electrical device has already suffered water ingress.

10. Method for measuring an extent of water ingress into an electrical device, wherein the method comprises:
receiving (S1) a change in resistance of the sensing circuit (10) according to any one of Claims 1 - 4;
determining (S2) an extent of water ingress into the electrical device according to the change in resistance.

11. Method according to claim 10, wherein the method further comprises:
measuring (S2-1) an amount of the change in resistance;
receiving (S2-2) a first resistance threshold and a second resistance threshold higher than the first resistance threshold;
comparing (S2-3) the amount of the change in resistance with the first resistance threshold and the second resistance threshold; and when the amount of the change in resistance is less than the first resistance threshold, outputting (S2-4) a signal indicating that the electrical device has not suffered water ingress;
when the amount of the change in resistance is greater than the first resistance threshold and less than the second resistance threshold, outputting (S2-4) a signal indicating that the electrical device is at risk of suffering water ingress; and
when the amount of the change in resistance is greater than the second resistance threshold, outputting (S2-4) a signal indicating that the electrical device has already suffered water ingress.

12. Determination circuit (11) for measuring an extent of water ingress into an electrical device, wherein the determination circuit (11) comprises:
a detector (111), for receiving a change in resistance of the sensing circuit (10) according to any one of Claims 1 - 4 and measuring an amount of the change in resistance;
a comparator (112), for receiving the amount of the change in resistance from the detector (111), and determining an extent of water ingress into the electrical device according to the amount of the change in resistance.

13. Determination circuit (11) according to claim 12, wherein the determination circuit (11) further comprises a threshold receiving end (113), for receiving a first resistance threshold and a second resistance threshold higher than the first resistance threshold.

14. Determination circuit (11) according to claim 13, wherein the comparator (112) receives the first resistance threshold and the second resistance threshold from the threshold receiving end (113), and compares the amount of the change in resistance with the first resistance threshold and the second resistance threshold, wherein, when the amount of the change in resistance is less than the first resistance threshold, the comparator (112) outputs a signal indicating that the electrical device has not suffered water ingress; when the amount of the change in resistance is greater than the first resistance threshold and less than the second resistance threshold, the comparator (112) outputs a signal indicating that the electrical device is at risk of suffering water ingress; and when the amount of the change in resistance is greater than the second resistance threshold, the comparator (112) outputs a signal indicating that the electrical device has already suffered water ingress.
